# EUROPÄISCHE PATENTSCHRIFT

(11) **EP 0 907 231 B1**
(45) Veröffentlichungstag und Bekanntmachung des Hinweises auf die Patenterteilung: **17.10.2001**
(21) Anmeldenummer: 98117656.3
(22) Anmeldetag: 17.09.1998
(51) Int. Cl.: H02B 1/044

(54) **Vorrichtung zum Befestigen von elektrischen oder elektronischen Bauteilen**
Mounting device for electric or electronic elements
Dispositif de fixation d'éléments électriques ou électroniques

(30) Priorität: 02.10.1997 DE 29717609 U
(43) Veröffentlichungstag der Anmeldung: 07.04.1999
(73) Patentinhaber: HANS BERNSTEIN SPEZIALFABRIK FÜR SCHALTKONTAKTE GmbH & CO., 32457 Porta Westfalica (DE)
(72) Erfinder: Wecke, Rolf Dipl.-Ing., 31675 Bückeburg (DE); Möller, Ulrich Dipl.-Ing., 31603 Diepenau (DE); Winkelhake, Werner Dipl.-Ing., 31675 Bückeburg (DE)
(74) Vertreter: Stracke, Alexander, Dipl.-Ing.

(56) Entgegenhaltungen:
- EP-A- 0 777 308
- WO-A-94/18731
- DE-A- 3 418 845
- US-A- 4 939 406

## Beschreibung

Die vorliegende Erfindung betrifft eine Vorrichtung zum Befestigen von elektrischen oder elektronischen Bauteilen wie z. B. von Sensoren, Sendern oder Empfängern von Lichtschranken, Schaltern oder dergleichen, an der Rückseite einer mit einer Bohrung versehenen Wandung, beispielsweise der Wandung eines Tür- oder Blendrahmenprofiles.

Elektrische oder elektronische Bauteile wie z. B. Sensoren, Sender oder Empfänger von Lichtschranken, Schalter oder dergleichen werden in vielen Anwendungfällen an der Rückseite einer mit einer Bohrung versehenen Wandung, beispielsweise der Wandung eines Tür- oder Blendrahmenprofiles, befestigt. Dabei kann die Bohrung dazu benutzt werden, beispielsweise Schaltknöpfe oder dergleichen von dem auf der Rückseite der Wandung liegenden elektrischen oder elektronischen Bauteil zur Vorderseite der Wandung hindurchragen zu lassen oder ganz einfach dazu, Sender oder Empfänger an der Rückseite einer Wandung derart zu plazieren, daß durch die Bohrung hindurch Signale ausgesendet oder empfangen werden können.

Unter einer Wandung ist im Rahmen der vorliegenden Erfindung nicht eine Gebäudewandung aus Stein oder Beton, sondern ausschließlich beispielsweise eine Wandung eines Tür- oder , eines Schaltgehäuses oder dergleichen zu verstehen, also eine vergleichsweise dünne Wandung.

Bislang werden elektrische oder elektronische Bauteile an derartigen Wandungen direkt oder über entsprechende Halterungen verschraubt. Häufig sind die entsprechenden Montagestellen schlecht zugänglich und entsprechend schwierig gestaltet sich dann die Montage bzw. das Anbringen entsprechender Bauteile.

Eine Vorrichtung zum Befestigen von elektrischen oder elektronischen Bauteilen an der Rückseite einer mit einer Bohrung versehenen Wandung, mit einem Halteteil, das mit einem Flansch sowie einem sich etwa lotrecht zum Flansch erstreckenden Teil, das mit einer für die Anlage eines keilförmigen Stückes bestimmten Hinterschneidung versehen ist, ist aus WO 94/18731 bekannt. Das Halteteil ist unter Anlage seines Flansches an der Vorderseite an einer Wandung durch ein auf der Rückseite der Wandung anliegende mit einem keilförmige Stück versehenen Halter an der Wandung festklemmbar. Die Konstruktion dieser Vorrichtung ist jedoch verhältnismäßig aufwendig.

Der vorliegenden Erfindung liegt die Aufgabe zugrunde, eine Vorrichtung der gattungsgemäßen Art zu schaffen, die sich einerseits durch einen einfachen Aufbau und andererseits durch eine einfache Montagemöglichkeit auch unter schwierigen bzw. beengten Raumverhältnissen auszeichnet.

Diese Aufgabe wird erfindungsgemäß durch die Merkmale des Anspruchs 1 gelöst.

Die erfindungsgemäße Vorrichtung besteht aus zwei vergleichsweise einfach herstellbaren Bauteilen, nämlich einem Halteteil und einem keilförmigen Klemmstück.

Das Halteteil mit seiner mit einem Abdeckflansch für die Bohrung versehenen Grundplatte und der daran angeschlossenen, etwa lotrecht zur Grundplatte verlaufenden Halterung wird durch die Bohrung einer Wandung hindurchgesteckt und auf der Rückseite der Wandung kann nun das festzulegende elektrische oder elektronische Bauteil von der Halterung fixiert werden. Zur Festlegung des ganzen wird dann das keilförmige Klemmstück unter Anlage an der Rückseite der Wandung aufgeschoben und dabei wird das Halteteil unter Anlage seines Abdeckflansches an der Vorderseite einer Wandung durch das auf der Rückseite der Wandung und an der Hinterschneidung anliegende keilförmige Klemmstück an der Wandung festgeklemmt. Diese Montage ist äußerst einfach durchzuführen und auch unter vergleichsweise beengten Platz- oder Raumverhältnissen möglich. Spezielle Werkzeuge werden nicht benötigt, da keinerlei Verschraubungen oder ähnliche Befestigungsarten Verwendung finden.

Vorteilhafte Ausgestaltungen der Erfindung sind Gegenstand von Unteransprüchen.

In den beigefügten Zeichnungen ist ein bevorzugtes Ausführungsbeispiel der Erfindung dargestellt, welches im folgenden näher beschrieben wird.

Es zeigen:
- Figur 1: einen Längsschnitt durch eine Wandung, an deren Rückseite ein elektrisches oder elektronisches Bauteil mittels einer erfindungsgemäßen Vorrichtung festgelegt ist,
- Figur 2: einen Schnitt nach der Linie II-II in Figur 1,
- Figur 3: die in Figur 1 mit III bezeichnete Einzelheit in vergrößerter Darstellung,

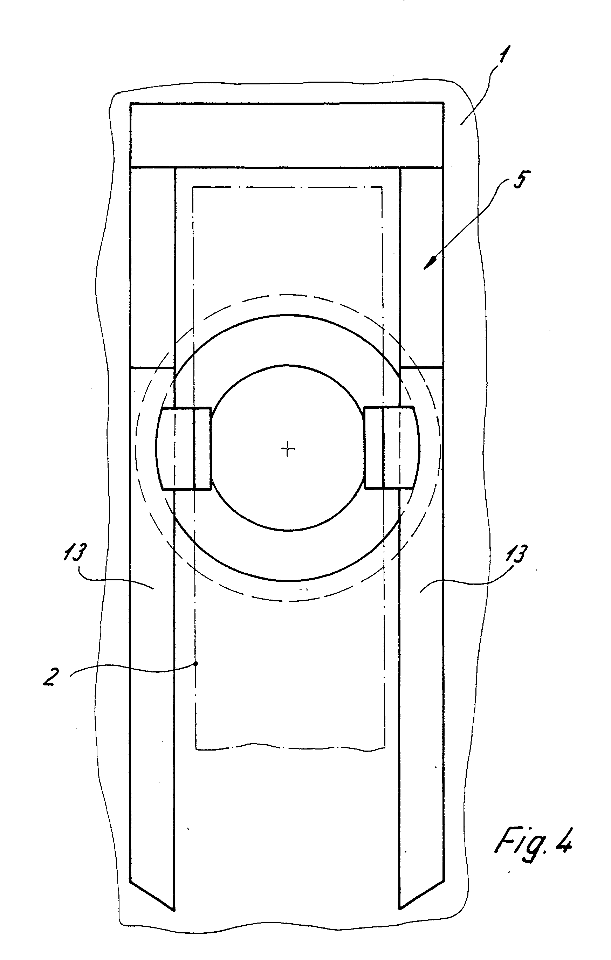

- Figur 4: eine Ansicht in Richtung des Pfeiles IV in Figur 1.

In den Zeichnungen ist mit dem Bezugszeichen 1 eine Wandung, beispielsweise die Wandung eines Tür- oder Blendrahmenprofiles, bezeichnet, an deren Rückseite 1a ein elektrisches oder elektronisches Bauteil, welches mit dem Bezugszeichen 2 bezeichnet ist, festgelegt ist. Im dargestellten Ausführungsbeispiel handelt es sich bei dem elektrischen oder elektronischen Bauteil um einen Sender oder einen Empfänger einer Lichtschranke. In diesem Falle ist das elektrische oder elektronische Bauteil 2 mit einer Linse 3 ausgestattet, über welche ein Signal ausgesendet oder empfangen werden kann.

Zur Festlegung des elektrischen oder elektronischen Bauteiles wird eine aus einem Halteteil 4 und einem keilförmigen Klemmnstück 5 bestehende Vorrichtung verwendet.

Das Halteteil 4 besteht im wesentlichen aus einer mit einem Abdeckflansch 6 versehenen Grundplatte 7 und einer sich etwa lotrecht zur Grundplatte 7 erstreckenden Halterung 8, welche Mittel zur Fixierung des festzulegenden elektrischen oder elektronischen Bauteiles 2 aufweist. Im dargestellten Ausführungsbeispiel besteht die Halterung 8 aus einer etwa Ü-förmigen Klammer, wobei die beiden Klammerschenkel an ihren freien Enden mit Rasthaken 9 ausgestattet sind, welche das zu fixierende elektrische oder elektronische Bauteil 2 hintergreifen. Andererseits liegt das zu fixierende elektrische oder elektronische Bauteil 2 auf der Grundplatte 7 des Halteteiles 4 auf.

Die Wandung 1 ist mit einer Bohrung 10 versehen, deren Durchmesser gleich oder größer ist als der größte Durchmesser der Grundplatte 7. Durch diese Bohrung 10 kann das Halteteil 8 durch die Wandung 1 hindurchgesteckt werden. Der Abdeckflansch 6 liegt unter Abdeckung der Randbereiche der Bohrung 10 an der Vorderseite 1b der Wandung 1 auf dieser Wandung auf.

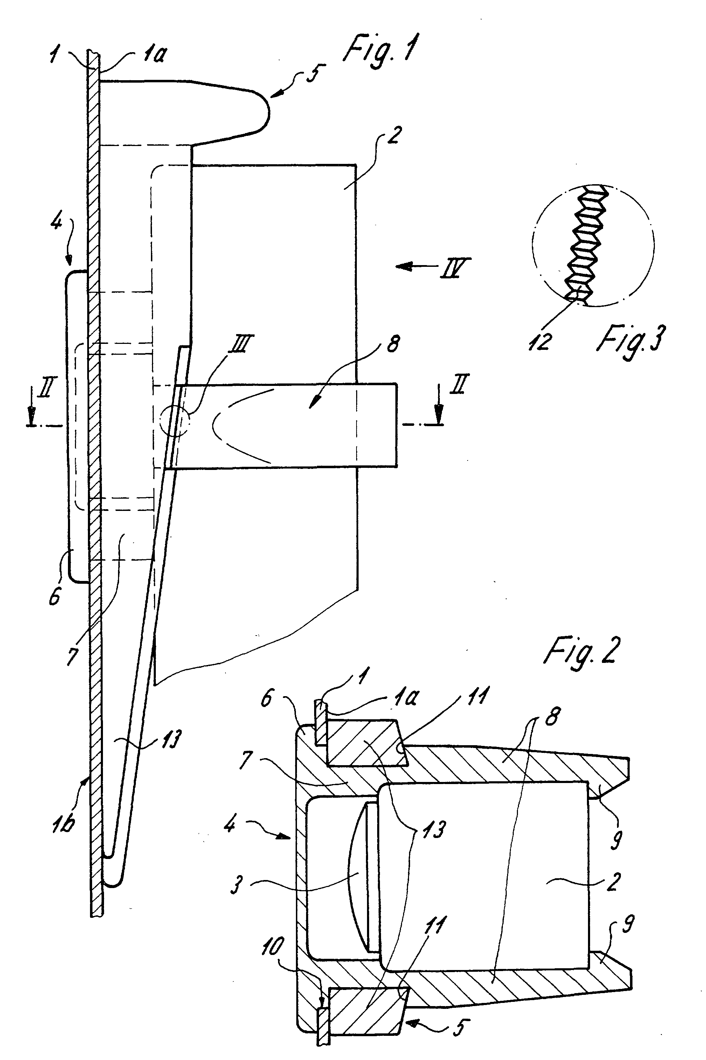

Das festzulegende elektrische oder elektronische Bauteil wird dann in die klammerartige Konstruktion des Halteteiles 8 eingerastet, so wie in Figur 2 dargestellt. Es kann durch konstruktive Mittel dafür Sorge getragen werden, daß eine Verrastung oder Fixierung des elektrischen oder elektronischen Bauteiles 2 am Halteteil 8 nur in einer solchen Position möglich ist, in der die Linse 3 oder ein anderes Funktionsteil, in einer Flucht mit der Bohrung 10 der Wandung 1 liegt.

Die beiden Schenkel der Halterung 8, die das elektrische oder elektronische Bauteil 2 seitlich umgreifen, sind jeweils mit Hinterschneidungen 11 versehen. Diese Hinterschneidungen 11 dienen dazu, die keilförmig gestalteten Seitenschenkel 13 des Klemmstückes 5 aufzunehmen. Das Klemmstück 5 liegt an der Rückseite 1a der Wandung 1 an und hintergreift, wie schon erwähnt, die Hinterschneidungen 11 der Halterung 8. Durch die Keilwirkung wird dabei der Abdeckflansch 6 fest an die Vorderseite 1b der Wandung 1 angezogen. Damit ist das elektrische oder elektronische Bauteil 2 sicher im Bereich seines bestimmungsgemäßen Einsatzortes gegenüber der Wandung festgelegt.

Um ein unbeabsichtigtes Lösen der Keilverbindung - beispielsweise durch Erschütterungen der Wandung 1 - auszuschließen, können die aneinanderliegenden Flächen der keilförmigen Seitenschenkel 13 einerseits und die Hinterschneidungen 11 andererseits mit einer Verzahnung 12 versehen sein, so wie dies in Figur 3 angeordnet ist.

Im dargestellten Ausführungsbeispiel handelt es sich bei dem elektrischen oder elektronischen Bauteil 2, wie schon oben erwähnt, um den Sender oder Empfänger einer Lichtschranke mit einer Linse 3. In einem derartigen Anwendungsfalle ist es ausreichend, wenn das Halteteil 4 zumindest in dem der Linse 3 gegenüberliegenden Bereich aus lichtdurchlässigem Material besteht. Das Halteteil 4 braucht also nicht durchbrochen zu sein. Wird in Abweichung vom dargestellten Ausführungsbeispiel ein elektrisches oder elektronischen Bauteil montiert, welches beispielsweise von der Vorderseite 1b der Wandung 1 aus mit einem zu bedienenden Schalterknopf versehen ist, muß das Halteteil 4 konzentrisch zur Bohrung 10 durchbrochen sein, damit eine Bedienung möglich ist. Alternativ hierzu kann in dem genannten Bereich auch eine Membran angeordnet sein, die das Bedienen eines Schalters ermöglicht.

Im dargestellten Ausführungsbeispiel ist die Halterung 8 zur Fixierung des elektrischen oder elektronischen Bauteiles klammerartig gestaltet. Abweichend hiervon kann je nach Gestaltung des elektrischen oder elektronischen Bauteiles 2 die Halterung 8 auch aus einem mit Rastmitteln versehenen Zapfen bestehen, der durch eine entsprechende Öffnung des elektrischen oder elektronischen Bauteiles 2 hindurchtritt oder in eine entsprechende Bohrung hineinragt, gewissermaßen nach Art eines Druckknopfverschlusses.

Vorteilhafterweise ist sowohl das Halteteil 4 wie auch das keilförmige Klemmstück 5 einstückig aus einem Kunststoff hergestellt.

## Patentansprüche

1. Vorrichtung zum Befestigen von elektrischen oder elektronischen Bauteilen wie z. B. von Sensoren, Sendern oder Empfängern von Lichtschranken, Schaltern oder dergleichen an der Rücksetie einer mit einer Bohrung versehenen Wandung (1) beispielsweise der Wandung (1) eines Tür- oder Blendrahmenprofiles, mit einem Halteteil (4) und einem keilförmigen Klemmstück (5), wobei das Halteteil (4) aus einer Grundplatte (7) mit einem Abdeckflansch (6) sowie einer sich etwa lotrecht zur Grundplatte (7) mit einem Abdeckflansch (6) sowie einer sich etwa lotrecht zur Grundplatte (7) erstreckenden Halterung (8) mit Mitteln zur Fixierung eines elektrischen oder elektronischen Bauteiles besteht und wobei die Halterung (8) oder die Grundplatte (7) mit mindestens einer für die Anlage des keilförmigen Klemmstückes (5) bestimmten Hinterschneidung (11) versehen ist, so daß das Halteteil (4) unter Anlage seines Abdeckflansches (6) an der Vorderseite an einer Wandung durch das auf der Rückseite der Wandung anliegende keilförmige Klemmstück (5) an der Wandung festklemmbar ist.

2. Vorrichtung nach Anspruch 1, **dadurch gekennzeichnet, daß** das Halteteil (4) in seinem mittleren, im montierten Zustand etwa konzentrisch zur Bohrung (10) liegenden Bereich aus einem lichtdurchlässigen Material besteht.

3. Vorrichtung nach Anspruch 1, **dadurch gekennzeichnet, daß** das Halteteil (4) in seinem mittleren, im montierten Zustand etwa konzentrisch zur Bohrung (10) liegenden Bereich mit einer Membran oder dergleichen ausgestattet ist.

4. Vorrichtung nach Anspruch 1, **dadurch gekennzeichnet, daß** das Halteteil (4) in seinem mittleren, konzentrisch zur Bohrung (10) liegenden Bereich mit einer Durchbrechung ausgestattet ist.

5. Vorrichtung nach einem oder mehreren der vorhergehenden Ansprüche, **dadurch gekennzeichnet, daß** die Halterung (8) etwa klammerförmig ausgebildet und mit zwei das festzulegende elektrische oder elektronische Bauteil (2) seitlich umgreifenden Schenkeln besteht, die an ihren freien Enden das elektrische oder elektronische Bauteil (2) hintergreifende Rasthaken (9) aufweisen.

6. Vorrichtung nach einem oder mehreren der vorhergehenden Ansprüche, **dadurch gekennzeichnet, daß** die aneinanderliegenden Flanken der Hinterschneidungen (11) einerseits und des keilförmigen Klemmstückes (5) andererseits mit einer Verzahnung (12) ausgestattet sind.

7. Vorrichtung nach einem oder mehreren der vorhergehenden Ansprüche, **dadurch gekennzeichnet, daß** das Halteteil (4) und das keilförmige Klemmstück (5) aus Kunststoff hergestellt sind.

## Claims

1. Device for fastening electrical or electronic components, such as for example sensors, transmitters or receivers of light barriers, switches or the like, on the rear side of a wall (1) provided with a drilled hole, for example the wall (1) of a door or frame profile, with a retaining part (4) and a wedge-shaped clamping piece (5), the retaining part (4) comprising a base plate (7) with a covering flange (6) and also a securing device (8) extending approximately perpendicularly with respect to the base plate (7), with means for fixing an electrical or electronic component, and the securing device (8) or the base plate (7) being provided with at least one undercut (11) intended for the abutment of the wedge-shaped clamping piece (5), so that the retaining part (4), with its covering flange (6) abutting the front side of a wall, can be. firmly clamped on the wall by the wedge-shaped clamping piece (5) abutting the rear side of the wall.

2. Device according to Claim 1, **characterized in that** the retaining part (4) consists of a transparent material in its central region, lying approximately concentrically with respect to the drilled hole (10) in the mounted state.

3. Device according to Claim 1, **characterized in that** the retaining part (4) is provided in its central region, lying approximately concentrically with respect to the drilled hole (10) in the mounted state, with a membrane or the like.

4. Device according to Claim 1, **characterized in that** the retaining part (4) is provided in its central region, lying concentrically with respect to the drilled hole (10), with an opening.

5. Device according to one or more of the preceding claims, **characterized in that** the securing device (8) is designed approximately in the form of a clasp and comprises two legs which grip laterally around the electrical or electronic component (2) to be fixed and have at their free ends catching hooks (9) gripping behind the electrical or electronic component (2).

6. Device according to one or more of the preceding claims, **characterized in that** the mutually abutting flanks of the undercuts (11) on the one hand and of the wedge-shaped clamping piece (5) on the other hand are provided with a serration (12).

7. Device according to one or more of the preceding claims, **characterized in that** the retaining part (4) and the wedge-shaped clamping piece (5) are produced from plastic.

## Revendications

1. Dispositif de fixation de composants électriques ou électroniques, tels que capteurs, émetteurs ou récepteurs de barrières optiques, interrupteurs ou similaires, à la face arrière d'une paroi (1) pourvue d'un trou, par exemple de la paroi (1) d'un profilé de cadre de porte ou de châssis dormant, comportant un élément de maintien (4) et une pièce de serrage (5) en forme de coin, l'élément de maintien (4) étant constitué d'une plaque de base (7) avec un flasque de couverture (6) ainsi que d'une fixation (8) s'étendant approximativement perpendiculairement à la plaque de base (7), avec des moyens de fixation d'un composant électrique ou électronique, et la fixation (8) ou la plaque de base (7) étant pourvue d'au moins un détalonnage (11) pour le contact avec la pièce de serrage (5) en forme de coin, de manière que l'élément de maintien (4), dont le flasque de couverture (6) s'applique contre la face avant d'une paroi, puisse être serré contre la paroi, par la pièce de serrage (5) en forme de coin s'appliquant contre la face arrière de la paroi.

2. Dispositif selon la revendication 1, **caractérisé en ce que** l'élément de maintien (4) est constitué d'une matière transparente, dans sa zone centrale, approximativement concentrique au trou (10), à l'état monté.

3. Dispositif selon la revendication 1, **caractérisé en ce que** l'élément de maintien (4) est pourvu d'une membrane ou similaire, dans sa zone centrale, approximativement concentrique au trou (10) à l'état monté.

4. Dispositif selon la revendication 1, **caractérisé en ce que** l'élément de maintien (4) est pourvu d'un ajour, dans sa zone centrale, approximativement concentrique au trou (10) à l'état monté.

5. Dispositif selon l'une ou plusieurs des revendications précédentes, **caractérisé en ce que** la fixation (8) est sensiblement en forme d'agrafe et est constituée de deux branches qui entourent latéralement le composant électrique ou électronique (2) à fixer, et qui comportent, à leurs extrémités libres, des crochets d'arrêt (9) qui passent derrière le composant électrique ou électronique (2).

6. Dispositif selon l'une ou plusieurs des revendications précédentes, **caractérisé en ce que** les flancs des détalonnages (11) d'une part et de la pièce de serrage (5) en forme de coin d'autre part sont pourvus d'une denture (12).

7. Dispositif selon l'une ou plusieurs des revendications précédentes, **caractérisé en ce que** l'élément de maintien (4) et la pièce de serrage (5) en forme de coin sont fabriqués en matière plastique.
